Europäisches Patentamt

(19) European Patent Office

Office européen des brevets

(11) Publication number: 0 163 313
A2

## (12) EUROPEAN PATENT APPLICATION

(21) Application number: 85106696.9

(22) Date of filing: 30.05.85

(51) Int. Cl.⁴: H 03 B 29/00
H 03 L 7/18, H 04 B 15/02

(30) Priority: 30.05.84 US 615193

(43) Date of publication of application:
04.12.85 Bulletin 85/49

(84) Designated Contracting States:
DE FR GB NL

(71) Applicant: TEKTRONIX, INC.
Tektronix Industrial Park D/S Y3-121 4900 S.W. Griffith
Drive P.O. Box 500
Beaverton Oregon 97077(US)

(72) Inventor: Crall, Richard F.
10 055 S.W. Wasco Way
Tualatin Oregon 97062(US)

(74) Representative: Weickmann, Heinrich, Dipl.-Ing. et al,
Patentanwälte Dipl.-Ing. H.Weickmann Dipl.-Phys.Dr.
K.Fincke Dipl.-Ing. F.A.Weickmann Dipl.-Chem. B. Huber
Dr.-Ing. H. Liska Dipl.-Phys.Dr. J. Prechtel Postfach
860820
D-8000 München 86(DE)

(54) Method and apparatus for spectral dispersion of the radiated energy from a digital system.

(57) Method and apparatus are disclosed for dispersing the electromagnetic energy radiated from a digital system to minimize the EMI and RFI emanating from such a system. To accomplish this, one approach of the present invention includes a VCO which is modulated by a band-limited signal to provide a system clock signal which has a broader spectral signature than the traditional precise crystal controlled oscillator traditionally utilized in digital systems. In addition, an optional feedback stage is disclosed for compensating for frequency drift of the VCO with time. This includes a precision crystal controlled oscillator operating at substantially the same frequency as the unmodulated VCO. This signal is then continuously compared with the modulated output signal of the VCO to generate a compensation signal which in turn is combined with the modulation signal to minimize the long-term errors and thus minimize the long-term drift of the modulated clock signal. Another approach disclosed is to modulate the amplitude of the bus voltage being provided for the digital system.

FIG. I

Croydon Printing Company Ltd

-1-

### METHOD AND APPARATUS FOR SPECTRAL DISPERSION OF THE RADIATED ENERGY FROM A DIGITAL SYSTEM

#### Background of the Invention

This invention relates to the reduction of RFI and EMI radiating from a digital system, more specifically, the broadening of the frequency spectrum of the master clock driving such a system to increase the bandwidth, and thereby reducing the magnitude, of the radiated signals.

As digital systems technology evolved, the timing of digital signals in the various signal paths of the system became more critical, one with respect to the other. To overcome these potential problems more and more precisely controlled crystal oscillators were developed to more closely synchronize the transition timing of the various signals within the system. Also, it made it easier to do real time calculations if one could rely on a particular program loop having precisely the same timing interval, no matter what the ambient temperature is or what power supply variations may be present. In short, the more precise crystal controlled oscillators made many problems a lot simpler, however in most applications a highly accurate crystal controlled oscillator is not mandatory. In these applications, a clock having a long-term stability, say over 1000 cycles, would be accurate enough for time keeping purposes without adversely affecting the operation of the system.

The down side to the use of the more and more accurate timing oscillators has been the greatly increased level of the RFI and EMI radiation from digital systems. This radiation, if left unchecked, will interfere with the performance of other systems, as well as radio communications. For this reason governmentally imposed limits on EMI and RFI emanations have been imposed. The objectionable radiation results from the confining of all of the transition energy in a very narrow bandwidth as a result of the precisely controlled frequency of the driving oscillator. Further, the more precise the frequency of the oscillator, the greater the synchronization of the signal transitions throughout the system with each component which experiences a transition radiating at precisely the same time as each other component that is also radiating; thus the entire digital system becomes one large antenna.

Traditionally, the oscillators have become more and more accurate, never less accurate, which only aggravates the emanation of RFI and EMI from a digital system which is so controlled. To suppress the undesirable radiation to acceptable levels, the prior art includes many techniques for masking or shielding of the digital system to contain the radiation. These include the use of expensive multi-layer printed circuit boards with a ground plane as one layer, metal housings with extensive shielding wherever two pieces of the housing meet, metal sprayed inside plastic surfaces or housings, as well as numerous clips, straps, etc. Even with all of the shielding, objectionable levels of RFI and EMI emanate from digital systems, particularly at harmonics and sub-harmonics of the oscillator frequency.

What is needed is a digital system master clock that is modulated in a controlled and statistically predictable manner. If a master clock or oscillator of this description were utilized in a digital system, the need for the expensive masking and shielding techniques mentioned above would be greatly reduced or eliminated. The present invention provides such a clock.

### Summary of the Invention

A method and apparatus is disclosed for dispersing the electromagnetic energy radiated from a digital system to minimize the EMI and RFI emanating from such a system. Disclosed are various embodiments for modulating the amplitude or frequency of the system clock, or the amplitude of the bus voltage within a limited band. Discussed herein is the use of frequency, phase, amplitude and pulse width modulation techniques. One embodiment includes a VCO which is modulated by a band-limited signal to provide a system clock signal which has a broader spectral signature than the precise crystal controlled oscillator traditionally utilized in digital systems. In addition, an optional feedback stage is disclosed for compensating for freuency drift of the VCO with time. This includes a precision crystal controlled oscillator operating at substantially the same frequency as the unmodulated VCO. This signal is then compared with the modulated output signal of the VCO to generate a compensation signal, which in turn is combined with the modulation signal to correct the accumulated error and thus minimize the long-term drift of the modulated clock signal.

In the embodiment for amplitude modulating the clock signal, the VCO is replaced with an amplifier and another oscillator is connected to provide its output signal to a multiplier. In all other respects this embodiment operates as discussed above without the feedback stage.

For pulse width modulation, the VCO and summer of the first embodiment discussed above is replaced with a pulse width modulator and oscillator which has its pulse tailing edge transition time determined by a signal from the modulation signal generator.

The modulated bus voltage embodiment includes a voltage controlled amplifier which is modulated by a band limited signal. Additionally, an optional feedback stage is included for compensating for voltage drift of the voltage controlled amplifier with time. This includes an integrator, for providing a long-term average of the modulated bus voltage, and a comparator.

-4-

The comparator then compares the average bus voltage with a fixed reference voltage which is selected to be equal to the specified bus voltage of the components of the system being powered to generate a compensation signal. The compensation signal is then combined with the modulation signal to correct the accumulated error and thus minimize the long term drift of the modulated bus voltage.

## Description of the Drawings

Figure 1 is a block diagram of a first embodiment of the present invention wherein the frequency of a clock signal is varied above and below a defined center frequency by a specified amount.

Figure 1A is a block diagram of a second embodiment of the present invention wherein the pulse width of the clock signal is varied within a limited range.

Figure 1B is a block diagram of a third embodiment of the present invention wherein the clock signal is amplitude modulated within a limited range.

Figure 2 is a block diagram of a fourth embodiment of the present invention wherein the system bus voltage is amplitude modulated a specified amount.

## Description of the Preferred Embodiment

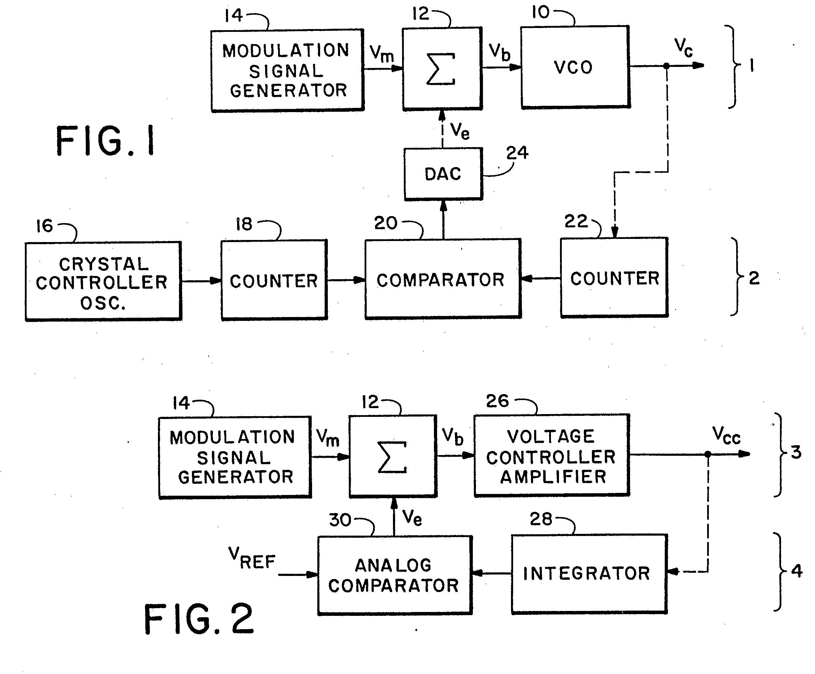

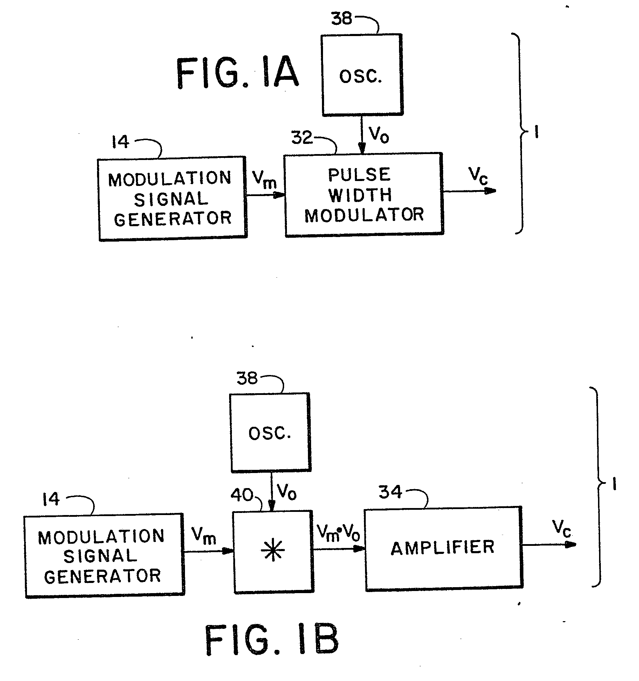

Figure 1 shows a block diagram wherein a master clock signal ($V_c$) for a digital system is produced having a broadened frequency spectrum, relative to the spectrum of a typical crystal controlled oscillator, to minimize the radiation emanating from any digital systems which it drives.

Figure 1 includes two stages: a master clock stage 1 and a feedback stage 2. The master clock stage 1 has a voltage controlled oscillator (VCO) 10 (e.g. 74LS124) being driven by a modulation signal generator 14 via summer 12, with summer 12 being unnecessary when the feedback stage 2 is not employed.

Since the desired result is for the output signal, $V_c$, to be band limited around the optimum operating frequency of the digital system, modulation signal generator 14 produces a band limited signal to achieve that result. These signals may include, for example any cyclical waveshape, pseudo random noise (which is cyclical) and band limited random noise. As the modulation signal, $V_m$, varies, the VCO is frequency modulated thereby and the frequency of $V_c$ varies accordingly. If $V_m$ is a ramp, then the frequency of the output from the VCO will sweep linearly from the lowest frequency to the highest frequency in the band and reset and repeat similar to a sweep frequency generator. The mathematics is simplified if $V_m$ is a sine wave, however, for maximum effectiveness, $V_m$ should be a band-limited random noise signal. A typical band-limited pseudo random noise generator is a National Semiconductor MM 5837.

To insure that the digital system functions correctly with the band limited clock signal, $V_c$, very short duration pulses of $V_c$ should be avoided. To accomplish this, the modulation signal, $V_m$, should have a limited voltage range.

The operation of the technique of Figure 1 was tested on a digital system which exhibited the typical radiation problems when operated with a precision oscillator. When a VCO with a center frequency of $F_o$ = 7.333 MHz was modulated by a ramp having a frequency of $F_m$ = 1.613 KHz with an amplitude adjusted to produce excursions of the VCO output between 6.666 MHz and 8.000 MHz, all radiation from the digital system, including that at $f_o$ and all of its harmonics and subharmonics, was well within allowable limits without the use of expensive masking, shielding and grounding techniques.

Without the optional feedback stage 2, the operation of the band-limited clock may drift over long periods of time. To overcome that problem, feedback stage 2 includes a crystal controlled oscillator 16, a pair of counters 18 and 22, a comparator 20 and a digital to analog converter (DAC) 24. Oscillator 16 is a precision oscillator with an output frequency that is selected to match the center frequency, $f_o$, of $V_c$. Both of counters 18 and 22 are free-running counters with the same maximum count capacity, say 1024, which are started together with counter 18 counting the output signal pulses from oscillator 16 and counter 22 counting the $V_c$ signal pulses. The output count of counters 18 and 22 are continuously applied to comparator 20 which generates an error signal, $V_e$, if these counts are not in agreement. The error signal, $V_e$, is then applied to summer 12, via DAC 24, where the corrected modulation signal, $V_b$ is generated, wherein:

$$V_b = V_m \pm V_e . \qquad (1)$$

In equation (1), $V_e$ is either added to, or subtracted from $V_m$, depending on whether the $f_o$ of $V_c$ is above or below the operating frequency of oscillator 16. Because of the mathematical similarities between frequency and phase modulation, the approach represented by Figure 1 could be considered to be either one.

Alternatively, the output frequency of oscillator 16 could be selected to be a fixed multiple of the center frequency of $V_c$, i.e. $kf_o$. In such a system, counters 18 and 22, or the gain of comparator 20 would be adjusted to account for the offset of the center frequency of oscillator 16 and VCO 10. For example, k could be 1/16, counter 18 would then need four fewer stages of flip-flops, thus locking $V_c$ onto a signal having a frequency that is 16 times its own, thus further dispersing the spectrum of the radiation. This approach is particularly interesting since the desired effect of the present invention is to reduce electromagnetic radiation.

By incorporating this optional feedback stage 2, we are again introducing the precision oscillator 16 which we had eliminated with the master clock stage 1. In this total configuration the oscillator 16 is still radiating, however, the only other portion of the circuit which is synchronized with it is counter 18. Therefore, only approximately two square inches of a circuit board of the unit is radiating. This is a very small percentage of the circuitry of a typical digital system, and the radiation level therefrom would be well within all radiation specifications. If need be, a small amount of shielding could be utilzed in the immediate area of oscillator 16 and counter 18 without going to complex, high cost masking, shielding and grounding techniques.

In addition, a broadening of the frequency spectrum of the radiated signals from a digital system will result when an amplitude modulated clock signal is utilized. To accomplish this result, one need only replace VCO 10 and summer 12 of Figure 1 with an amplifier 34 and a multiplier 40, respectfully, and add an oscillator 38 with its output signal applied to the multiplier as shown in Figure 1B. The output frequency of oscillator 38 is selected to be the desired center frequency for the system clock. In this embodiment feedback stage 2 is not necessary.

Another option for modulating the system clock signal is the use of pulse width modulation (PWM) wherein the width of the pulses varies cyclically or randomly. In such a system, the leading edge of each pulse occurs at a selected rate and the trailing edge timing of each pulse is determined by a cyclic or random signal. Figure 1A shows a master clock stage 1 for implementing the PWM technique in a detailed block diagram. This implementation includes a pulse width modulator 32 (e.g. NE555) for generating the PWM output signal $V_c$. The frequency, or timing, of the leading edges of the $V_c$ clock pulses is controlled by the frequency of the signal from oscillator 38, and the timing of the trailing edges of the $V_c$ clock pulses is controlled by the modulation signal, $V_m$ , from modulation signal generator 14. In this embodiment feedback stage 2 is not necessary.

In essence, in the embodiment of Figure 1, the long-term drift of the frequency of the signal $V_c$ is constrained so that it does not exceed an absolute value determined by the count length of counters 18 and 22. Thus, as the measurement interval is increased, the long-term percentage drift relative to the crystal controlled oscillator 16 approaches zero. While the embodiments of Figures 1A and 1B have the advantage of not needing to be corrected for long-term drift by the addition of a feedback network, they are not as effective at dispersing the EMI and RFI emanations as the embodiment depicted in Figure 1.

Referring now to Figure 2 there is shown a block diagram, similar to the diagram of Figure 1. Those blocks which are the same have the same reference numbers. The system represented by Figure 2 is for producing a bus voltage, $V_{cc}$ , which varies within a limited range of voltages under the influence of a selected cyclical or random signal.

Figure 2 includes two stages: a master bus voltage stage 3 and a feedback stage 4. The master bus voltage stage 3 has a voltage controlled amplifier (VCA) 26 driven by the modulation signal generator 14 via summer 12, with summer 12 being unnecessary when the feedback stage 4 is not employed. This produces a bus voltage signal, $V_{cc}$ , which varies a selected amount around the specified bus voltage for the system to be powered thereby. By modulating $V_{cc}$ within the minimum rated bus voltage tolerance (i.e. $\pm$ 5% for most semiconductor components) of the powered system components, the frequency spectrum of the signals radiated from that system will be broadened by a corresponding percentage.

To correct for long-term drift, and other errors, feedback stage 4 can be included. It includes an analog comparator 30, a stable source for a fixed voltage, $V_{REF}$, and integrator 28. $V_{REF}$ is a fixed voltage which is equal to the specified bus voltage of the components of the system to be powered. The signal $V_{REF}$ and the average value of $V_{cc}$ from integrator 28 are applied to comparator 30 for the generation of error voltage, $V_e$ , if there is a difference between $V_{REF}$ and $V_{cc\ ave}$. Note that if $V_{REF}$ is a fraction or a multiple of the specified bus voltage, then the gain of comparator 30 will have to be adjusted accordingly to generate an appropriate error voltage.

While the preferred ebodiments of the present invention have been shown and described, it will be apparent to those skilled in the art that many changes and modifications may be made without departing from the invention in its broader aspects. Therefore, the appended claims are intended to cover all such modifications and changes that fall within the true spirit and scope of the invention.

I Claim:

1. A method of generating a digital system master clock signal comprising the steps of:

a. generating a clock signal of a selected center frequency and amplitude; and

b. modulating the clock signal of step a. within a limited band.

2. A method as in claim 1 wherein the modulation type of step b. is frequency modulation.

3. A method as in claim 1 wherein the modulation type of step b. is phase modulation.

4. A method as in claim 1 wherein the modulation type of step b. is amplitude modulation.

5. A method as in claim 1 wherein the modulation type of step b. is pulse width modulation.

6. A method as in claim 1 wherein the modulation type of step b. utilizes a cyclical signal.

7. A method as in claim 6 wherein the cyclical signal is a pseudo-random signal.

8. A method as in claim 1 wherein the modulation type of step b. utilizes a band limited random signal.

9. A method as in claim 1 further including the steps of:

c. generating a precision frequency signal having a center frequency with substantially a fixed relationship to the center frequency of step a.;

d. generating a compensation signal from the signal from step c. and the resultant signal of steps a. and b.; and

e. modifying the signal of step b. in response to the signal of step d. to correct the accumulated error of the resultant signal of steps a. and b. with respect to the signal of step c.

10. A method as in claim 9 wherein step d. includes the steps of:

f. counting the cycles of the generated signal of step c.;

g. counting the cycles of the resultant signal of steps a. and b.; and

h. comparing the counts of steps f. and g. and generating the compensation signal therefrom.

11. A method as in claim 9 wherein the center frequency of the precision frequency signal of step c. is substantially the same as the center frequency of the clock signal of step a.

12. A method as in claim 9 wherein the center requency of the precision frequency signal of step c. is k times the center frequency of the clock signal of step a., k being any positive factor including fractions less than and greater than the numeral 1.

13. A method as in claim 9 wherein the counting of steps c. and d. is modified to account for the factor k difference of the two frequency signals.

14. A method as in claim 10 wherein the comparing step h. is modified to account for he factor k difference of the two frequency signals.

15. A method as in claim 9 wherein step e. includes the step of:

i. converting the signal of step h. to an analog signal; and

j.    summing the modulation signal of step b. with the analog compensation signal of step i.

16.    Apparatus for generating a digital system master clock signal comprising:
means for generating a clock signal of a selected center frequency and amplitude; and
means for modulating the clock signal within a limited band.

17.    Apparatus as in claim 16 wherein the type of modulation is frequency modulation.

18.    Apparatus as in claim 16 wherein the type of modulation is phase modulation.

19.    Apparatus as in claim 16 wherein the type of modulation is amplitude modulation.

20.    Apparatus as in claim 16 wherein the type of modulation is pulse width modulation.

21.    Apparatus as in claim 16 wherein the modulation signal is cyclical.

22.    Apparatus as in claim 16 wherein the cyclical signal is a pseudo random signal.

23.    Apparatus as in claim 16 wherein the modulation signal is a band limited random signal.

24.    Apparatus as in claim 16 further including:
means for generating a precision frequency signal having a center frequency with substantially a fixed relationship with the center frequency of the clock signal;

0163313

means for generating a compensation signal from the precision frequency signal and the modulated clock signal; and

means for modifying the modulation signal in response to the compensation signal to correct the accumulated error of the modulated clock signal with respect to the precision frequency signal.

25. Apparatus as in claim 24 wherein the means for generating a compensation signal includes:

means for counting the cycles of the precision frequency signal;

means for counting the cycles of the modulated clock signal; and

means for comparing the counts of the precision frequency signal and the modulated clock signal and generating the compensation signal therefrom.

26. Apparatus as in claim 24 wherein the center frequency of the precision frequency signal is substantially the same as the center frequency of the modulated clock signal.

27. Apparatus as in claims 24 wherein the center frequency of the precision frequency signal is k times the center frequency of the modulated clock signal, k being any positive factor including fractions less than and greater than the numeral 1.

28. Apparatus as in claim 24 wherein the two counting means are modified to account for the factor k difference of the two frequency signals.

29. Apparatus as in claim 25 wherein the comparison means is modified to account for the factor k difference of the two frequency signals.

30. Apparatus as in claim 24 wherein the modification means includes:

means for converting the resultant comparison signal from the comparison means to an analog signal; and

means for summing the modulation signal with the analog comparison signal.

31. Apparatus as in claim 16 wherein:

said generating means includes a voltage controlled oscillator; and

said modulating means includes a band-limited random noise signal generator.

32. Apparatus as in claim 24 wherein said precision frequency signal generating means includes a crystal controlled oscillator.

33. Apparatus as in claim 16 wherein said modulating means includes:

means for producing a pulse width modulation signal; and

signal generator means for generting a selected signal for application to the pulse width modulation means to determine the width of said pulses.

34. Apparatus as in claim 33 wherein said generator means generates a cyclical signal.

35. Apparatus as in claim 33 wherein said generator means generates a band limited random signal.

36. A method of generating a digital system bus voltage signal comprising the steps of:

a. generating a bus voltage of a selected amplitude; and

b.    modulating the bus voltage of step a. within a limited range.

37.    A method as in claim 36 further including the steps of:

c.    integrating the modulated bus voltage signal;

d.    generating a compensation signal from the integrated modulated bus voltage signal and a fixed reference voltage having substantially the same value as the b.s voltage of step a.; and

e.    modifying the signal of step b. in response to the signal of step d. to correct the accumulated error of the modulated bus voltage with respect to the fixed reference voltage.

FIG. 1

FIG. 2

0163313

0163313

## FIG. IA

38 — OSC.

14 — MODULATION SIGNAL GENERATOR

$V_m$

32 — $V_0$

PULSE WIDTH MODULATOR

$V_c$

1

## FIG. IB

38 — OSC.

14 — MODULATION SIGNAL GENERATOR

$V_m$

40 — $V_0$

＊

$V_m \cdot V_0$

34 — AMPLIFIER

$V_c$

1